(19) Europäisches Patentamt
European Patent Office
Office européen des brevets

(11) **EP 3 419 062 A1**

(12) **EUROPEAN PATENT APPLICATION**
published in accordance with Art. 153(4) EPC

(43) Date of publication:
**26.12.2018 Bulletin 2018/52**

(51) Int Cl.:
**H01L 33/50** $^{(2010.01)}$

(21) Application number: **16909522.1**

(86) International application number:
**PCT/JP2016/071394**

(22) Date of filing: **21.07.2016**

(87) International publication number:
**WO 2018/016047 (25.01.2018 Gazette 2018/04)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(71) Applicant: **Sanken Electric Co., Ltd.**
**Niiza-shi, Saitama 352-8666 (JP)**

(72) Inventors:
• **MUROFUSHI, Hitoshi**
**Niiza-shi**
**Saitama 352-8666 (JP)**

• **HOSHINO, Masanori**
**Niiza-shi**
**Saitama 352-8666 (JP)**
• **TANAKA, Yoshinori**
**Niiza-shi**
**Saitama 352-8666 (JP)**

(74) Representative: **Grünecker Patent- und
Rechtsanwälte
PartG mbB
Leopoldstraße 4
80802 München (DE)**

(54) **LIGHT-EMITTING DEVICE**

(57) A light emitting device includes: a first light emitting unit (10) which includes: a first blue light emitting element (11) emitting emission light with the peak wavelength being a first wavelength; and a first phosphor layer (12) and outputs white light of a first chromaticity; and a second light emitting unit (20) which includes: a second blue light emitting element (21) emitting emission light the peak wavelength being a second wavelength, the second wavelength being longer than the first wavelength; and a second phosphor layer; and outputs white light of a second chromaticity. In an xy chromaticity diagram, the first and second chromaticities are located symmetrically with respect to a predetermined chromaticity, and the difference between the predetermined chromaticity and each of the first and second chromaticities is not greater than 0.04.

FIG. 1

EP 3 419 062 A1

**Description**

[Technical Field]

The present invention relates to a light emitting device that outputs light by exciting a phosphor.

[Background Art]

Light emitting devices that include a light emitting element, such as a light emitting diode (LED), and a phosphor excited by the light emitting element are in practical use. In an LED lighting device of about 2500 to 7500 K, for example, desired chromaticity points comparatively following black body radiation are implemented with a combination of light emission spectra of light emitted from the LED and light emitted from the phosphor. Herein, light emission due to black body radiation and daylight (approximated to black body radiation) has continuous spectra by the nature thereof. On the other hand, general LED white light has a combination of spectra, that is, exhibits a discontinuous synthetic spectrum. LED white light therefore has different quality from light emission due to black body radiation even if having the same chromaticity.

In terms of the quality of light, such as color rendering properties, for example, black body radiation or reflected color of daylight are the most preferable. There are some evaluation methods of the quality of light using black body radiation or daylight as an index of 100. The most popular one of such evaluation methods is color rendering indices (CRIs) determined by International Commission on Illumination (CIE). CRIs evaluate differences in a color space between irradiation of 15 types of test colors (R1 to R15) with object light and irradiation thereof with reference light (black body radiation or daylight) corresponding to a desired color temperature. Herein, the color rendering indices include a general color rendering index Ra (the average of R1 to R8) and special color rendering indices Ri (i = 9 to 15).

In order to improve color rendering properties of LED lighting, various measures have been made. In such measures, there is an attempt to implement extremely high color rendering properties comparable to AAA fluorescent lamps (Ra > 95, Ri > 90 (JIS Z9112: Ri > 88)) or higher. The Japanese government project, "Light of the 21st Century" (1998-2002) and the like have proposed a method of expressing visible colors with excitation of RGB phosphors and the like by using a near ultraviolet or violet LED as a light source. This method is still the mainstream in developing LEDs with extremely high color rendering properties (see Patent Literature 1, for example).

This method excites a phosphor to emit blue light. The luminous efficiency thereof is about half of that of typical white LEDs because of the loss due to the conversion efficiency of phosphors. Furthermore, high efficiency phosphors are still developing. The above method therefore has a bunch of problems from the viewpoint of energy conservation and cost reduction. In the structure according to another method, therefore, RG phosphors are controlled using two blue LEDs as excitation light sources. The structure provides extremely high color rendering properties without reducing the efficiency while having a reliability equal to general white LEDs (see Patent Literature 2, for example).

[Citation List]

[Patent Literature]

[PTL 1] Japanese Patent Laid-open Publication No. 2011-29497
[PTL 2] Japanese Patent Application No. 2015-100664

[Summary of Invention]

[Technical Problem]

The aforementioned method provides extremely high color rendering properties at a color temperature of 3000 to 6000 K but hardly provides such high color rendering properties at lower or higher color temperatures. Furthermore, even at color temperatures in the aforementioned range, the spectral shape that can be implemented is limited depending on the desired chromaticity, and there are some chromaticity points where the color rendering properties are slightly low. The ratio in intensity of the two blue peaks, that is a major factor to control the spectral shape, can be controlled only by selection of the elements but cannot be controlled by design. Such poor flexibility is a significant problem in actual manufacturing.

An object of the invention is to provide a light emitting device which outputs white light of a predetermined chromaticity with all the color rendering indices being high in a wide color temperature of 2000 to 10000 K by controlling the output ratio of two blue light emitting elements by design.

[Solution to Problem]

According to an aspect of the invention, a light emitting device includes: (i) a first light emitting unit which includes: a first blue light emitting element that emits first emission light having an emission spectrum in which the peak wavelength is a first wavelength; and a first phosphor layer which is excited with the first emission light to emit a first excitation light, and outputs white light of a first chromaticity which is a mixture of the first emission light and the first excitation light, and (ii) a second light emitting unit which includes: a second blue light emitting element that emits second emission light having an emission spectrum in which the peak wavelength is a second wavelength, the second wavelength being longer than the first wavelength; and a second phosphor layer which is excited with the second emission light to emit a second excitation light, and outputs white light of a second chromaticity which is a mixture of the second emission light and the second excitation light. In an xy chromaticity diagram, the first chromaticity and second chromaticity are located symmetrically with respect to a predetermined chromaticity, and the difference between the predetermined chromaticity and each of the first and second chromaticities is not greater than 0.04, and the white light of the first chromaticity and the white light of the second chromaticity are mixed to be outputted as light of the predetermined chromaticity.

[Advantageous Effects of Invention]

According to the invention, it is possible to provide a light emitting device which outputs white light of a predetermined chromaticity with all the color rendering indices being high in a wide color temperature range from 2000 to 10000 K.

[Brief Description of Drawings]

FIG. 1 is a schematic diagram illustrating the configuration of a light emitting device according to a first embodiment of the invention.
FIG. 2 is a graph illustrating an emission spectrum example of white light obtained by using a first blue light emitting element.
FIG. 3 is a table illustrating color rendering index examples of the white light obtained by using the first blue light emitting element.
FIG. 4 is a graph illustrating an emission spectrum example of white light obtained by using a second blue light emitting element.
FIG. 5 is a table illustrating color rendering index examples of the white light obtained by using the second blue light emitting element.
FIG. 6 is a graph illustrating an emission spectrum example of output light obtained by mixing the two white lights.
FIG. 7 is a table illustrating color rendering index examples of the output light obtained by mixing the two white lights.
FIG. 8 is a schematic diagram illustrating the configuration of a light emitting device of a comparative example.
FIG. 9 is a graph illustrating the relationship of output light from the light emitting device of the comparative example between color temperature and color rendering indices.
FIG. 10 is a graph illustrating the emission spectrum of the output light of the light emitting device of the comparative example.
FIG. 11 is an xy chromaticity diagram illustrating the chromaticity of the output light from the light emitting device of the comparative example.
FIG. 12 is a schematic diagram for explaining a method to reduce a color difference using a chromaticity vector.
FIG. 13 is a uniform chromaticity scale diagram in the L*a*b* color space.
FIG. 14 is a graph illustrating spectral distributions of color rendering indices.
FIG. 15 is an xy chromaticity diagram for explaining a chromaticity difference.
FIGS. 16(a) to 16(b) are schematic diagrams for explaining rotation of the chromaticity vector, FIG. 16(a) illustrating the case where the rotation angle is 0 to 135 degrees; FIG. 16(b) illustrating the case where the rotation angle is 180 to 315 degrees.
FIG. 17 is a graph illustrating the relationship for color rendering index R9 between the difference and rotation angle.
FIG. 18 is a graph illustrating the relationship for to color rendering index R12 between the difference and rotation angle corresponding.
FIG. 19 is a graph illustrating the relationship between the color rendering index and rotation angle.

FIG. 20 is a graph illustrating the relationship between the color rendering index and chromaticity difference.

FIG. 21 is a graph illustrating the relationship between general color rendering index Ra and a light output ratio of the light emitting units.

FIG. 22 is a graph illustrating the relationship between the color rendering index R9 and the light output ratio of the light emitting units.

FIG. 23 is a graph illustrating the relationship between the color rendering index R10 and the light output ratio of the light emitting units.

FIG. 24 is a graph illustrating the relationship between the color rendering index R11 and the light output ratio of the light emitting units.

FIG. 25 is a graph illustrating the relationship between the color rendering index R12 and the light output ratio of the light emitting units.

FIG. 26 is a table comparing the color rendering indices of output light of the light emitting device according to the first embodiment of the invention with that of the light emitting device of the comparative example.

FIG. 27 is a graph illustrating an emission spectrum example of excitation light emitted from a green phosphor.

FIG. 28 is a graph illustrating an emission spectrum example of excitation light emitted from a red phosphor.

FIG. 29 is a graph illustrating an emission spectrum example of light emitted from a blue light emitting element.

FIG. 30 is a graph illustrating an emission spectrum example of output light from the light emitting device according to the first embodiment of the invention.

FIG. 31 is a plan view schematically illustrating a substrate arrangement example of a lighting device composed of the light emitting devices according to the first embodiment of the invention.

FIG. 32 is a plan view schematically illustrating a configuration of a light emitting device according to a second embodiment of the invention.

FIG. 33 is a plan view schematically illustrating another configuration of the light emitting device according to the second embodiment of the invention.

[Description of Embodiment]

Next, embodiments of the invention are described with reference to the drawings. In the following description of the drawings, the same or similar portions are given the same or similar symbols. The embodiments below exemplify devices and methods to embody the technical idea of the invention. The technical idea of the invention will not specify the shape, structure, and arrangement of constituent components and the like to ones described below. Various changes can be added to the embodiments of the invention within the claims.

(First Embodiment)

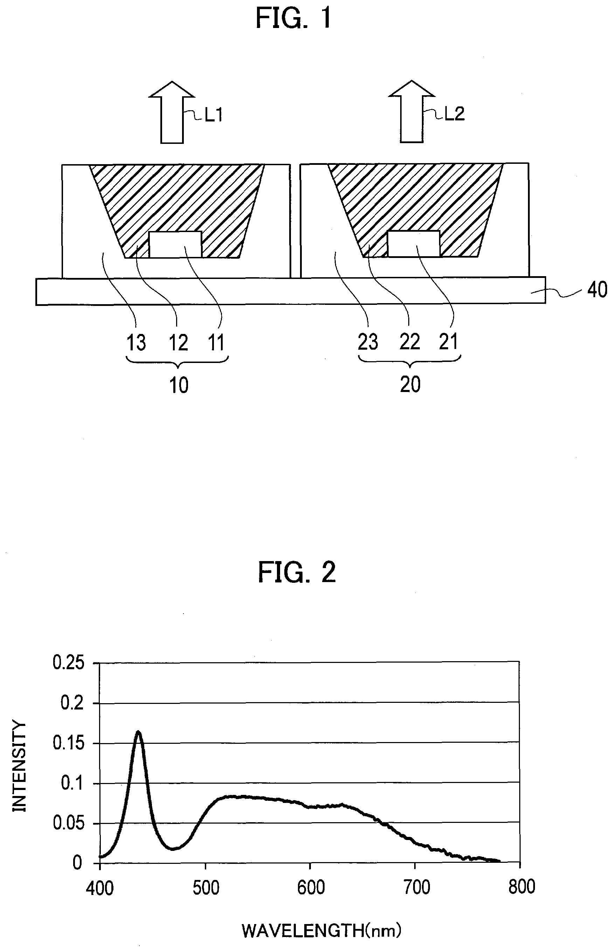

As illustrated in FIG. 1, a light emitting device according to the first embodiment of the invention includes a first light emitting unit 10 that outputs white light L1 having a first chromaticity C1; and a second light emitting unit 20 that outputs white light L2 having a second chromaticity C2. The light emitting device of FIG. 1 mixes the white light L1 from the first light emitting unit 10 and the white light L2 from the second light emitting unit 20 to output light having a predetermined chromaticity. The first and second light emitting units 10 and 20 are placed close to each other in a range that allows the white light L1 and white light L2 to be mixed. In an xy chromaticity diagram, the first and second chromaticities C1 and C2 are located symmetrically with respect to the predetermined chromaticity (described later in detail). The difference between each of the first and second chromaticities C1 and C2 and the predetermined chromaticity is not greater than 0.04.

For convenience of explanation, the first and second chromaticities C1 and C2 are described as chromaticity points. Actually, each of the first and second light emitting units 10 and 20 are manufactured so as to fall within about a 4-step MacAdam ellipse around the respective chromaticities and are combined so as to fall within about a 3-step MacAdam ellipse. The differences between the predetermined chromaticity and the first and second chromaticities C1 and C2 indicate lengths between the position of the predetermined chromaticity and the positions of the first and second chromaticities C1 and C2, respectively. The first and second chromaticities C1 and C2 are located at symmetrical positions with respect to the predetermined chromaticity. The lengths between the predetermined position and the first and second chromaticities C1 and C2 are determined depending on the brightness of the white light L1 and white light L2, respectively.

The first light emitting unit 10 includes: a first blue light emitting element 11 that emits first emission light; and a first phosphor layer 12 that is excited with the first emission light to emit first excitation light. The peak wavelength in the emission spectrum of the first emission light is set to a first wavelength. Herein, the peak wavelength refers to a wavelength at which the intensity is maximized in the emission spectrum. The first light emitting unit 10 outputs the white light L1 having the first chromaticity C1, as a mixture of the first emission light and first excitation light. The first phosphor layer 12 includes phosphors, such as green and red phosphors. The components and composition of the phosphors are determined so that the first light emitting unit 10 outputs the white light L1 having the first chromaticity C1.

The second light emitting unit 20 includes: a second blue light emitting element 21 that emits second emission light; and a second phosphor layer 22 that is excited with the second emission light to emit second excitation light. The peak wavelength in the emission spectrum of the second emission light is set to a second wavelength. The second light emitting unit 20 outputs the white light L2 having the second chromaticity C2, as a mixture of the second emission light and second excitation light. The second phosphor layer 22 includes phosphors. The components and composition of the phosphors are determined so that the second light emitting unit 20 outputs the white light L2 having the second chromaticity C2. Normally, the first and second phosphor layers 12 and 22 are different in components and composition of the contained phosphors.

The first and second blue light emitting elements 11 and 21 are different in peak wavelength in the emission spectra. Specifically, the first wavelength, as the peak wavelength of the emission light from the first blue light emitting element 11, is shorter than the second wavelength, as the peak wavelength of the emission light from the second blue light emitting element 21. As described later, the difference between the first and second wavelengths is preferably 20 to 40 nm. In the following description, the first and second blue light emitting elements 11 and 21 are collectively referred to as blue light emitting elements. The blue light emitting elements are blue LEDs, for example.

As illustrated in FIG. 1, for example, the first light emitting unit 10 has a structure in which a first package 13 includes a recessed portion and the first blue light emitting element 11 is placed on the bottom of the recessed portion. The recessed portion of the first package 13 is filled with the first phosphor layer 12. The second light emitting unit 20 has the same structure as that of the first light emitting unit 10. A second package 23 includes a recessed portion, and the second blue light emitting element 21 is placed on the bottom of the recessed portion. The recessed portion of the second package 23 is filled with the second phosphor layer 22. The first and second phosphor layers 12 and 22 are made of silicon resin including phosphors and the like. In the following description, the first and second light emitting units 10 and 20 are collectively referred to as light emitting units.

The first and second packages 13 and 23 are mounted on a substrate 40. In the substrate 40, not-illustrated electric wires are provided. The electric wires connect to the first and second blue light emitting elements 11 and 21. When voltage is applied to the first and second blue light emitting elements 11 and 21 through the electric wires, driving current flows, and the first and second blue light emitting elements 11 and 21 emit light.

As already described, the first and second blue light emitting elements 11 and 21 are different in peak wavelength in the emission spectrum. According to the light emitting device illustrated in FIG. 1, therefore, the disadvantages of blue LEDs, which have a narrow half-value width, are covered, and the color rendering index R12, which is likely to be low, can be raised. According to the light emitting device illustrated in FIG. 1, it is possible to implement the same level of brightness as general LED lighting devices through excitation by blue LEDs.

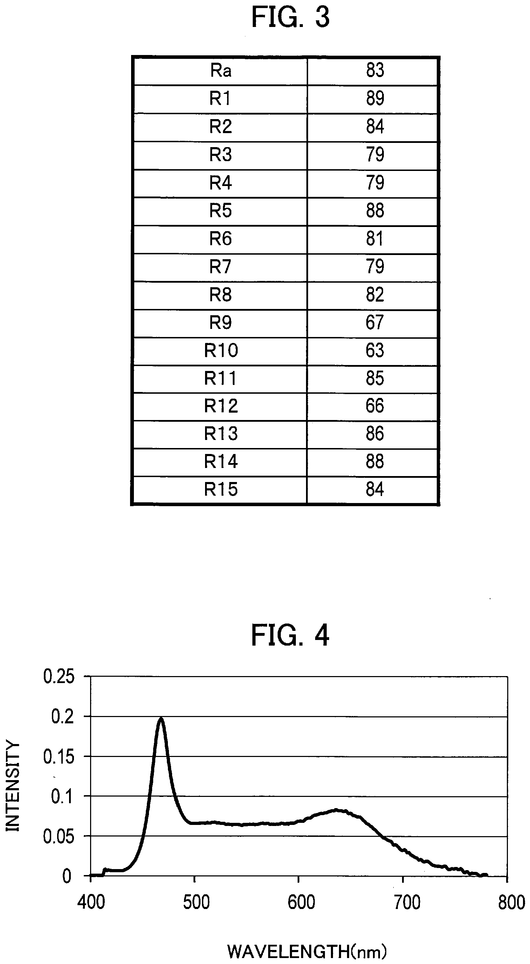

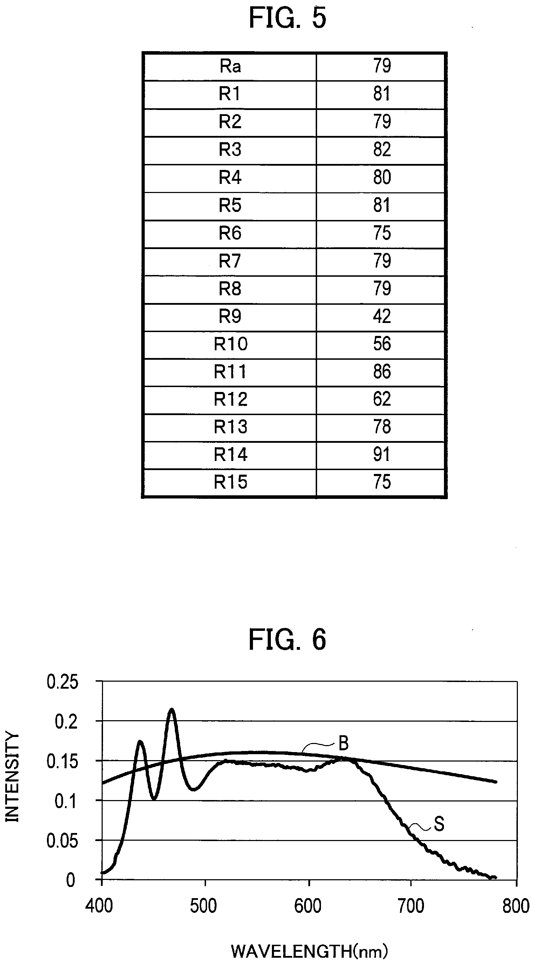

Mixing of the white lights obtained by using the two blue light emitting elements having different peak wavelengths is described below. It is assumed that the white light obtained by using the first blue light emitting element 11 and phosphors has an emission spectrum illustrated in FIG. 2 and color rendering indices illustrated in FIG. 3. It is assumed that the white light obtained by using the second blue light emitting element 21 and phosphors has an emission spectrum illustrated in FIG. 4 and color rendering indices illustrated in FIG. 5. Some of the color rendering indices illustrated in FIGS. 3 and 5 are not greater than 70.

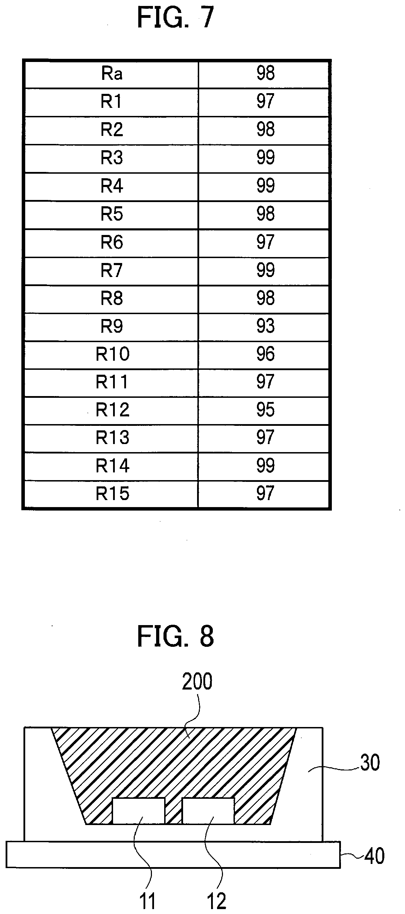

Herein, the chromaticity of the white light obtained by using the first blue light emitting element 11 and the chromaticity of the white light obtained by using the second blue light emitting element 21 are configured so as to be located symmetrically with respect to a desired target chromaticity in the xy chromaticity diagram. FIG. 6 illustrates an emission spectrum S of white light obtained by mixing the two white lights with the chromaticities set as described above. FIG. 7 illustrates the color rendering indices thereof. As illustrated in FIG. 6, the emission spectrum S is approximated to a spectrum B of black body radiation, which exhibits an emission spectrum of reference light of 5000 K determined by CIE. As illustrated in FIG. 7, the color rendering indices are not less than 90 in the entire region.

As described above, white light having a target chromaticity is obtained by mixing the two white lights with the chromaticities set symmetrically with respect to the target chromaticity. The color rendering indices of the obtained white light are raised in the entire region. This is because the intensities of the two blue light emitting elements having different peak wavelengths are controlled as described above.

In the case of creating output light of low chromaticity, the amount of phosphors that use blue light is small, and the emission light from the blue light emitting element is less reduced. The intensity of blue light in the emission light has a high peak value. On the other hand, in the case of creating output light of high chromaticity, the amount of phosphors that use the blue light is large, and the intensity of blue light in the emission light has a low peak value. The intensity of blue light is controlled by changing the chromaticity in such a manner. It is therefore possible to output light of high color rendering properties in a wide range from 2000 to 10000 K.

By using the two blue light emitting elements having different peak wavelengths, the intensity of the white light obtained by mixing can be increased in the entire wavelength region of blue light. On the other hand, it is difficult to increase the intensity across the wavelength region of blue light in the case of using a single blue light emitting element.

After a great deal of consideration, the inventors have found that controlling the spectral shape with the phosphor layer that is excited by the blue light emitting element is also important to provide output light of a desired chromaticity with all the color rendering indices being high. The consideration is described below.

As illustrated in FIG. 8, first, consideration is made for a comparative example having the following structure: the first and second blue light emitting elements 11 and 21 are placed on the bottom of the recessed portion of a same package 30; and the recessed portion of the package 30 is filled with a phosphor layer 200. The light emitting device of the comparative example illustrated in FIG. 8 is also considered as follows. The first and second blue light emitting elements 11 and 21 are separately provided in different packages, and the recessed portions of the packages are filled with phosphor layers of the same components and the same composition of phosphors. In other words, the comparative example mixes the output lights having different fixed chromaticities that depend on only the difference in peak wavelength between the blue light emitting elements.

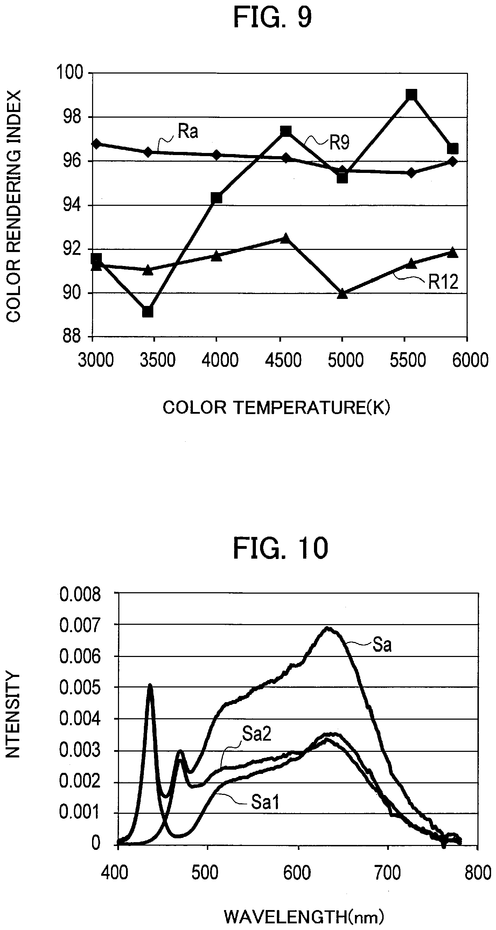

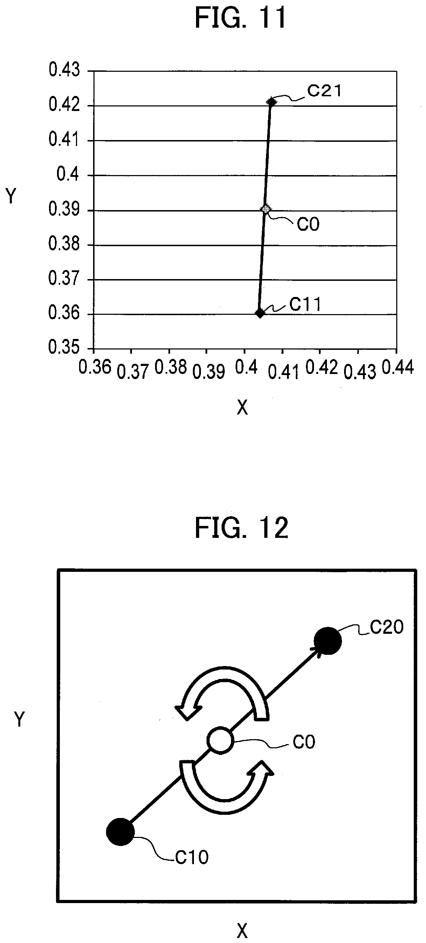

FIG. 9 illustrates the general color rendering index Ra and the color rendering indices R9 and R12 of the output light from the light emitting device illustrated in FIG. 8 when the light emitting device is designed to have an emission spectrum of black radiation at 3000 to 6000 K. In FIG. 9, the color rendering index R9 is low at 3500 K. This is because the difference between the peak values of the intensities of the first and second blue light emitting elements 11 and 21 is large as illustrated in FIG. 10. FIG. 10 illustrates an emission spectrum Sa of the output light from the light emitting device illustrated in FIG. 8; an emission spectrum Sa1 of the output light obtained by using the first blue light emitting element 11; and an emission spectrum Sa2 of the output light obtained by using the second blue light emitting element 21. As illustrated in the xy chromaticity diagram of FIG. 11, the chromaticity C11 of the output light obtained by using the first blue light emitting element 11 and the chromaticity C21 of the output light obtained by using the second blue light emitting element 21 are positioned symmetrically with respect to target chromaticity C0.

As described above using the comparative example, it is difficult to raise all the color rendering indices of white light that depends on only the difference between the peak wavelengths of the blue light emitting elements. Furthermore, since the chromaticities C11 and C21 are determined by the selected peak wavelengths, the target chromaticity is fixed. The comparative example therefore has low flexibility. In addition, when the blue light emitting elements vary in wavelengths, it is difficult for the light emitting device to output light having a desired chromaticity.

In the light emitting device illustrated in FIG. 1, the chromaticities of the output light from the first light emitting unit 10 and the output light from the second light emitting unit 20 are configured so that the output light from the light emitting device has a desired chromaticity and all the color rendering indices thereof are high. Specifically, the chromaticities of the white lights L1 and L2 outputted from the first and second light emitting units 10 and 20 are set to the first and second chromaticities C1 and C2, respectively, so that the color rendering properties of the output light be maximized. The first light emitting unit 10 is formed so that the chromaticity of the white light L1 is the first chromaticity C1 while the second light emitting unit 20 is formed so that the chromaticity of the white light L2 is the second chromaticity C2. The method of setting the first and second chromaticities C1 and C2 is described below.

As illustrated in FIG. 12, the line connects the chromaticity C10 of the output light from the first light emitting unit 10 as the start point to the chromaticity C20 of the output light from the second light emitting unit 20 as the end point (hereinafter, referred to as a chromaticity vector) is rotated about the target chromaticity C0, that is the midpoint between the chromaticities C10 and C20. Rotating the chromaticity vector in such a manner is equivalent to changing the spectral shape while maintaining the chromaticity. While the chromaticity vector is being rotated, the positions of the chromaticities C10 and C20 are determined so as to minimize the color difference corresponding to the distance between the target chromaticity C0 and each of the chromaticities C10 and C20 in the L*a*b* color space.

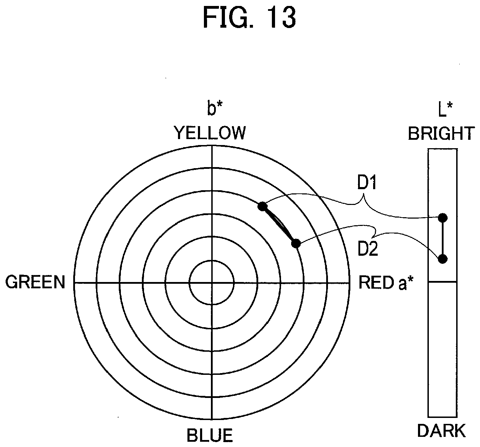

This is because the color rendering indices Rj (j = 1 to 15) are expressed by the following expression (1) using a color difference ΔE, corresponding to the distance between reference light indicated by coordinates D1 and sample light indicated by coordinates D2 in the L*a*b* color space (illustrated in FIG. 13).

$$Rj = 100 - 4.6 \times \Delta Ej \quad \ldots(1)$$

As shown by the expression (1), the smaller the color difference ΔE, the higher the color rendering properties. In order to raise the color rendering indices to higher than 90, the color difference ΔE is preferably not greater than 2. In order to further raise the color rendering indices, the color difference ΔE is more preferably not greater than 1.

The color difference ΔE, corresponding to the distance between reference light and sample light in the L*a*b* color space, is expressed by the following expression (2).

$$\Delta E = \{(\Delta L)^2 + (\Delta a)^2 + (\Delta b)^2\}^{1/2} \quad ...(2)$$

Herein, $\Delta L = |L1 - L2|$, $\Delta a = |a1 - a2|$, and $\Delta b = |b1 - b2|$ where the coordinates D1 and D2 are coordinates (L1, al, b1) and coordinates (L2, a2, b2), respectively.

The above description is given of the differences $\Delta L$, $\Delta a$, and $\Delta b$, which are elements of the color difference $\Delta E$ in the L*a*b* color space for easy understanding. In the followings, consideration is given concerning differences $\Delta W$, $\Delta U$, and $\Delta v$, which indicate the distance between coordinates (W1, U1, v1) of reference light and coordinates (W2, U2, v2) of sample light in the W*U*v* color space (JIS Z8726) . Herein, $\Delta W = |W1 - W2|$, $\Delta U = |U2 - U1|$, and $\Delta v = |v1 - v2|$.

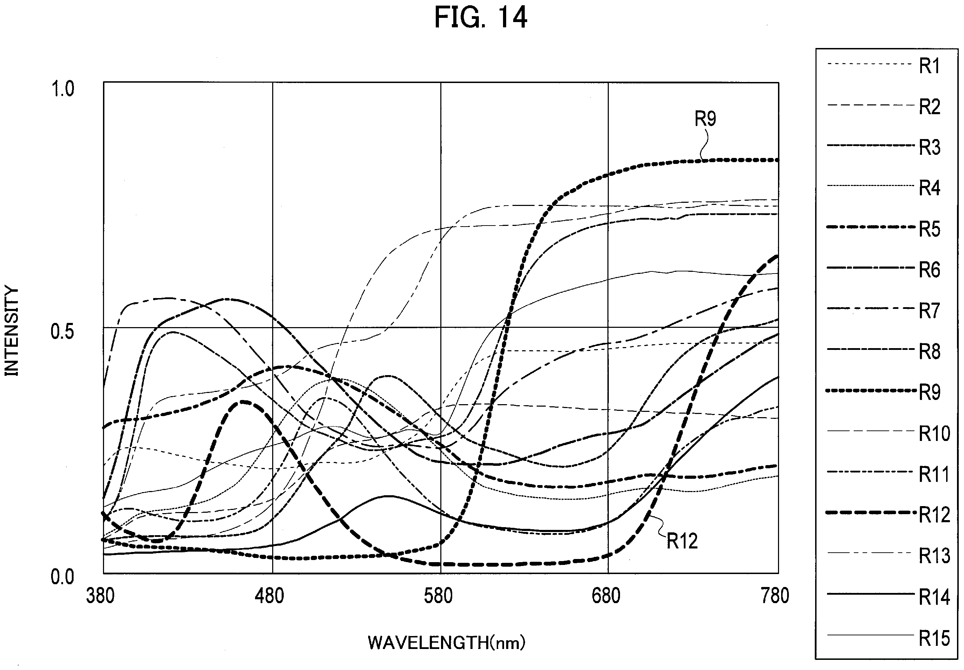

FIG. 14 illustrates spectral distributions of the color rendering indices R1 to R15. The horizontal axis of FIG. 14 represents wavelength while the vertical axis represents intensity. The color rendering index R9, which corresponds to the red component, and the color rendering index R12, which corresponds to the blue component, are extremely important in color rendering evaluation. The spectral distributions of the color rendering indices R9 and R12 (illustrated in FIG. 14) exhibit contrasting characteristics. It is therefore necessary to determine the condition under which the differences $\Delta W$, $\Delta U$, and $\Delta v$, that are the elements of the color difference $\Delta E$ in the W*U*v* color space, are small for both the color rendering indices R9 and R12 as the chromaticity vector is rotated.

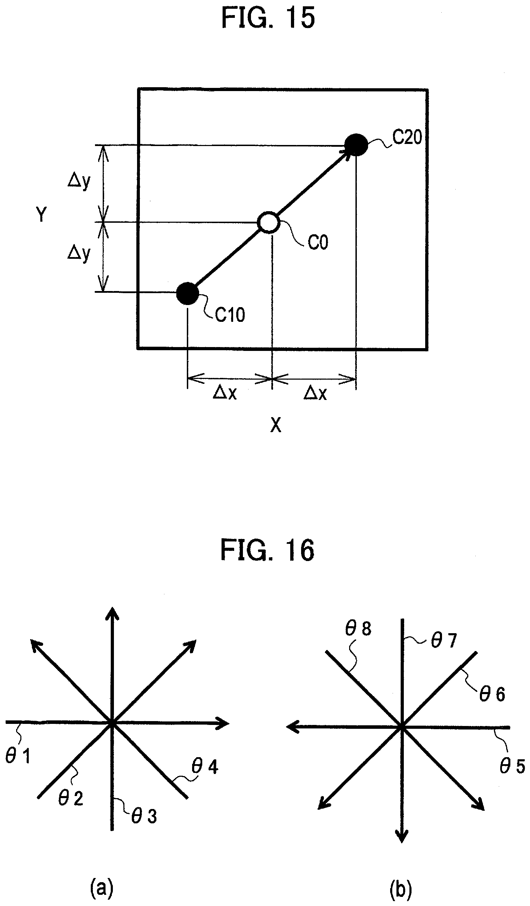

The color difference $\Delta E$ depends on the chromaticity difference $\Delta C$ in the xy chromaticity diagram between the target chromaticity C0 and each of the chromaticities C10 and C20 and color temperature set for the output light from the light emitting device. The chromaticity difference $\Delta C$ is expressed by the following expression (3) using the difference $\Delta x$ in x coordinates and the difference $\Delta y$ in y coordinates between the target chromaticity C0 and each of the chromaticities C10 and C20 illustrated in FIG. 15.

$$\Delta C = \{(\Delta x)^2 + (\Delta y)^2\}^{1/2} \quad ...(3)$$

In the following description, the chromaticity difference $\Delta C$ is 0.015, and the color temperature is 3500 K.

Herein, the +x direction in the xy chromaticity diagram is referred to as a reference direction. The angle between the reference direction and the forward direction of the chromaticity vector which is rotated counterclockwise from the reference direction is referred to as a rotation angle $\theta$. The rotation angle $\theta$ is 0 degree when the direction of the chromaticity vector is the same as the reference direction. FIG. 16(a) illustrates $\theta 1 = 0$ degree, $\theta 2 = 45$ degrees, $\theta 3 = 90$ degrees, and $\theta 4 = 135$ degrees, and FIG. 16(b) illustrates $\theta 5 = 180$ degree, $\theta 6 = 225$ degrees, $\theta 7 = 270$ degrees, and $\theta 8 = 315$ degrees.

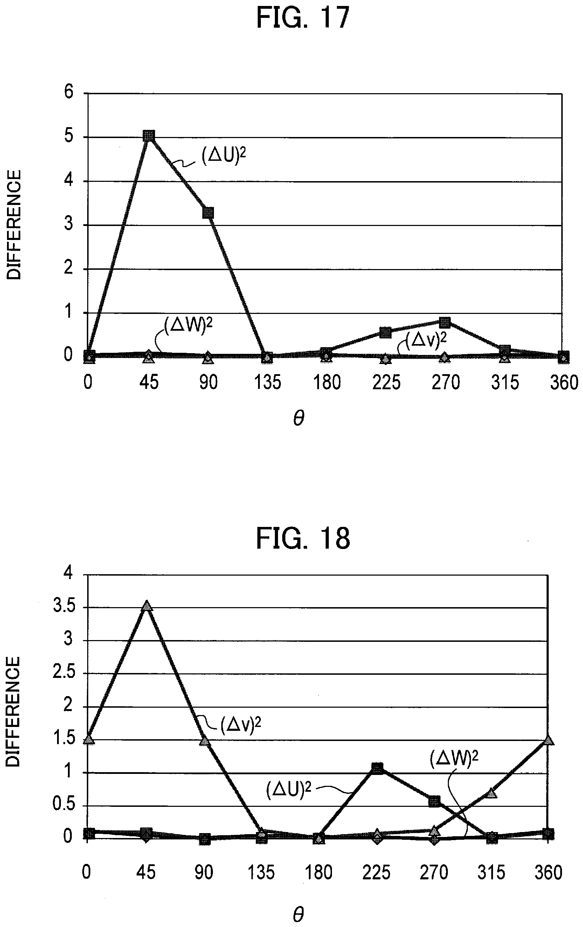

FIG. 17 illustrates the relationship for the color rendering index R9 between the rotation angle $\theta$ and squares of the differences $\Delta W$, $\Delta U$, and $\Delta v$. As illustrated in FIG. 17, the square of the difference $\Delta U$ takes a local maximum value. The squares of the differences $\Delta W$, $\Delta U$, and $\Delta v$ are small when the rotation angle $\theta$ is 135 to 180 degrees and 315 to 360 degrees.

FIG. 18 illustrates the relationship for the color rendering index R12 between the rotation angle $\theta$ and squares of the differences $\Delta W$, $\Delta U$, and $\Delta v$. As illustrated in FIG. 18, the square of each of the differences $\Delta U$ and $\Delta v$ takes a local maximum value. The squares of the differences $\Delta W$, $\Delta U$, and $\Delta v$ are small when the rotation angle $\theta$ is 135 to 180 degrees.

As described above, only $\Delta U$ and $\Delta v$ are involved in the color difference $\Delta E$. Rotating the chromaticity vector produces periodicity in the color difference $\Delta E$. FIGS. 17 and 18 show that the color difference $\Delta E$ is reduced for the color rendering indices R9 and R12 when the rotation angle $\theta$ is 135 to 180 degrees. In other words, in the xy chromaticity diagram, when the angle between the line that connects the chromaticity C10 as the start point to the chromaticity C20 as the end point and the +x direction of the xy chromaticity diagram is set to 135 to 180 degrees, the color rendering properties are improved. The chromaticity C10 when the rotation angle $\theta$ is 135 to 180 degrees is set as the first chromaticity C1 while the chromaticity C20 is set as the second chromaticity C2.

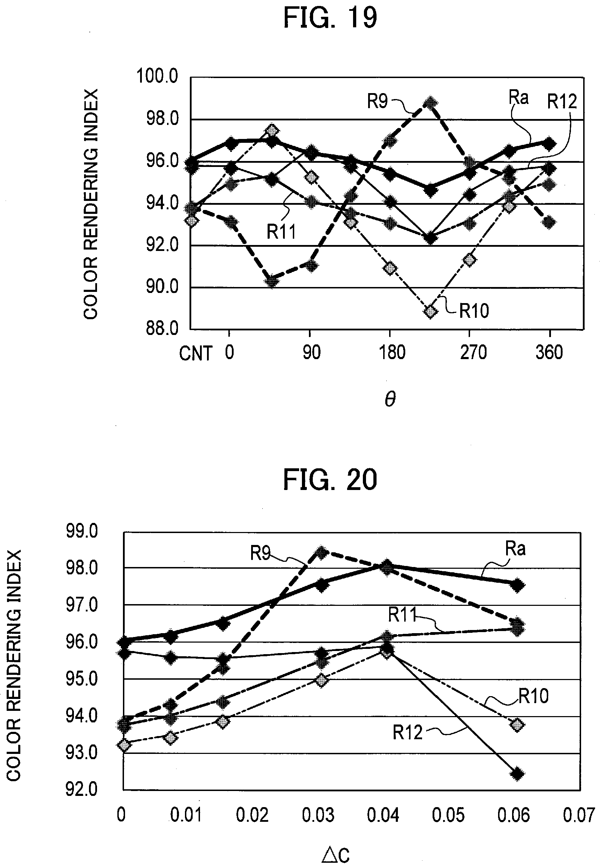

Next, consideration is made on the influence of the light outputs and the chromaticity difference $\Delta C$ of the light emitting units on the color rendering properties. FIG. 19 illustrates the relationship between the rotation angle $\theta$ and the general color rendering index Ra and color rendering indices R9, R10, R11, and R12 at 5000 K. In FIG. 19, CNT indicates the case where the chromaticities C10 and C20 are equal to the target chromaticity C0, that is, the chromaticity difference $\Delta C$ is 0 (the same applies hereinafter). As illustrated in FIG. 19, high color rendering properties are obtained in the case where the rotation angle $\theta$ is 315 to 360 (0) degrees, and 135 degrees and in the case of CNT. In the followings, consideration is made for the wide range of rotation angle $\theta$, 315 to 360 degrees, by way of example. The rotation angle $\theta$ at which high color rendering properties are provided changes if the target chromaticity changes.

FIG. 20 illustrates the relationship between the chromaticity difference $\Delta C$ and the general color rendering index Ra and color rendering indices R9 to R12 when the rotation angle θ is 315 degrees. As illustrated in FIG. 20, the color rendering properties are high when the chromaticity difference ΔC is in a range from 0.03 to 0.04. When the chromaticity difference ΔC is greater than 0.04, the color rendering properties are reduced, and the color rendering indices vary. The color rendering index R12 is particularly reduced significantly. In order to minimize the color difference ΔE, the chromaticity difference ΔC is preferably not greater than 0.04.

Adjustment of the chromaticity difference ΔC is equivalent to adjustment of the height of the peak in the emission spectrum of the output light from each light emitting unit. The value of the chromaticity difference ΔC optimal to provide high color rendering properties depends on the ratio of light outputs from the light emitting units. The relationship between the light output ratio and the general color rendering index Ra and color rendering indices R9 to R12 is described below. Herein, the light output ratio is a ratio (P2/P1) of a light output P2 from the second light emitting unit 20 to a light output P1 from the first light emitting unit 10.

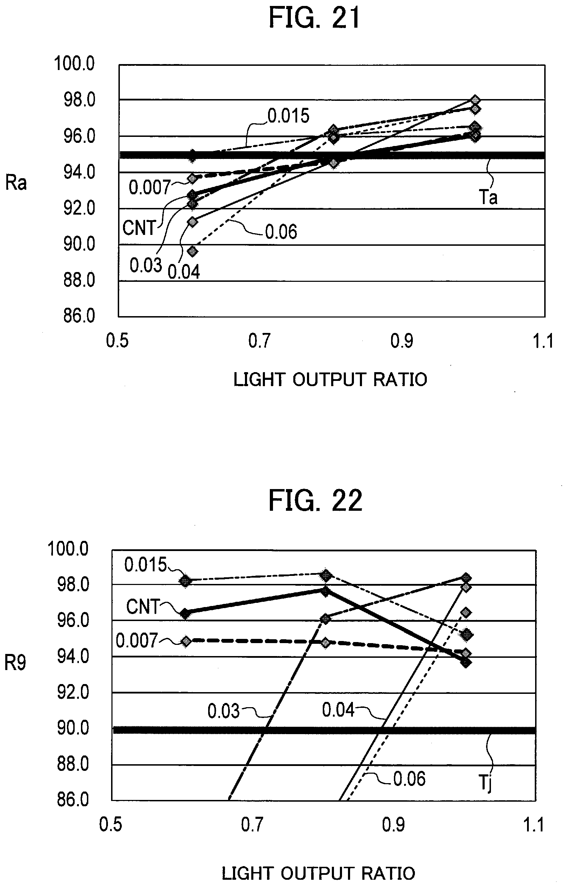

FIG. 21 illustrates the relationship between the general color rendering index Ra and the light output ratio in the case of CNT and in the cases where the chromaticity difference ΔC is 0.007, 0.015, 0.03, 0.04, and 0.06. Threshold Ta for high color rendering properties is set to 95. As illustrated in FIG. 21, the general color rendering index Ra exceeds the threshold Ta at a light output ratio > 0.8 when the chromaticity difference ΔC is 0.015, 0.03, and 0.06.

FIGS. 22 to 25 illustrate the relationship between the color rendering indices R9, R10, R11, and R12 and light output ratio, respectively. Each of FIGS. 22 to 25 illustrates the relationship between the color rendering index and light output ratio in the case of CNT and in the cases where the chromaticity difference ΔC is 0.007, 0.015, 0.03, 0.04, and 0.06. Threshold Tj for high color rendering properties is set to 90.

As illustrated in FIG. 22, the color rendering index R9 exceeds the threshold Tj at a light output ratio > 0.8 in the case of CNT and in the cases where the chromaticity difference ΔC is 0.007, 0.015, and 0.03.

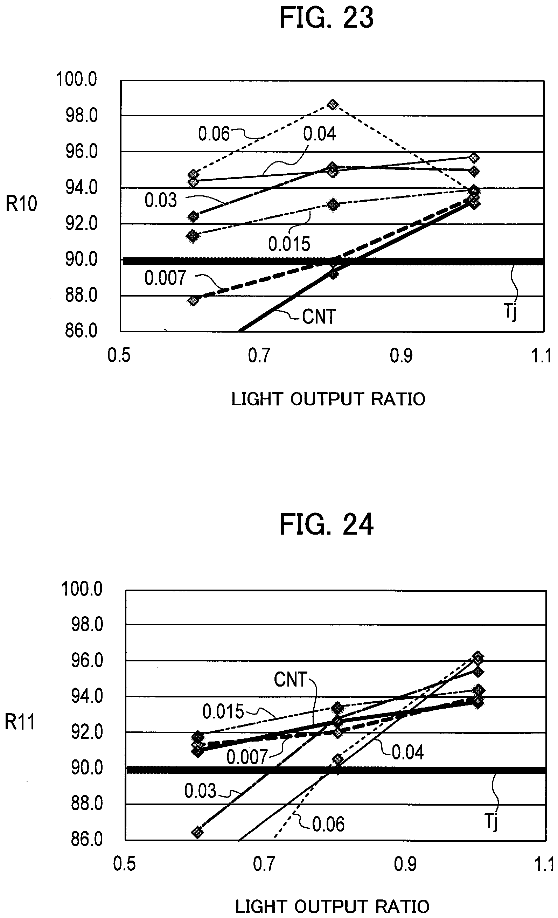

As illustrated in FIG. 23, the color rendering index R10 exceeds the threshold Tj at a light output ratio > 0.8 when the chromaticity difference ΔC is 0.007, 0.015, 0.03, 0.04, and 0.06.

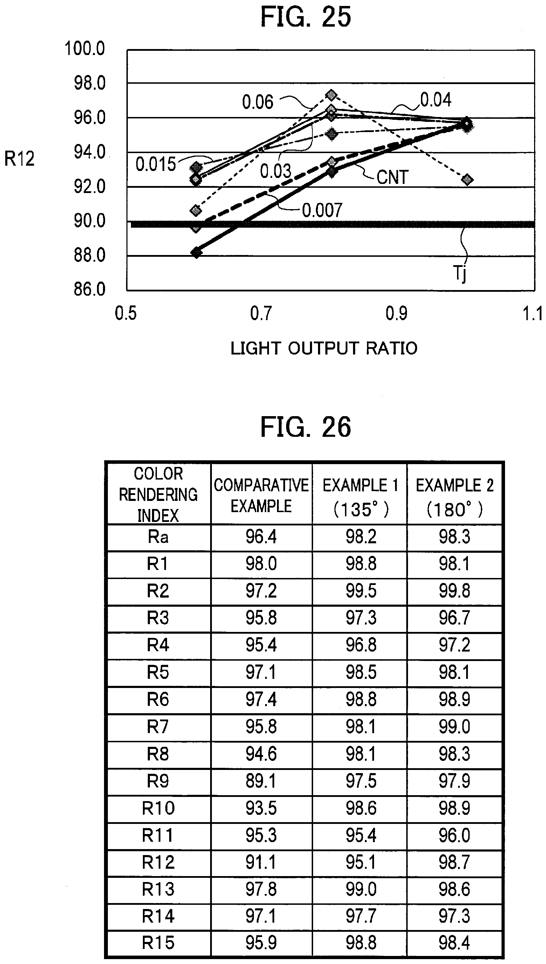

As illustrated in FIGS. 24 and 25, the color rendering indices R11 and R12 exceed the threshold Tj at a light output ratio > 0.8 for CNT and all the values of the chromaticity difference ΔC.

The criterion for high color rendering properties are met at a light output ratio > 0.8 for all of the general color rendering index Ra and color rendering indices R9 to R12 when the chromaticity difference ΔC is 0.015 and 0.03. The range of the optimal value of the chromaticity difference ΔC changes when the target chromaticity changes.

As described with reference to FIGS. 20 to 25, the inventors have found that the color difference ΔE can be small when the chromaticity difference ΔC was not greater than 0.04. In order to implement high color rendering properties, therefore, the chromaticity difference ΔC of the light emitting device is preferably set to not greater than 0.04. The color rendering properties can be high especially when the chromaticity difference ΔC is not less than 0.01. Consequently, the chromaticity difference ΔC is more preferably not less than 0.01 and not greater than 0.04. As described above, the case where the chromaticities C10 and C20 are located symmetrically with respect to the target chromaticity C0 is advantageous to the case of CNT in the light of improving the color rendering properties.

In the aforementioned consideration, the light output ratio is set greater than 0.8 as the standard, taking into an account of the wavelength balance of the emission spectrum and the target chromaticity of the output light from the light emitting device. It is predicted that the range of light output ratio > 1 can provide the same results as those of the aforementioned consideration although the optimal value of the rotation angle θ is different. The case where P1 < P2 does not exist actually.

In the light emitting device, the peak wavelength of each blue light emitting element and the components and composition of the phosphor layer are adjusted in order that the rotation angle θ and chromaticity difference ΔC are set optimal for high color rendering properties. The first light emitting unit 10 is therefore configured so that the chromaticity of the white light L1 is the first chromaticity C1. The second light emitting unit 20 is configured so that the chromaticity of the white light L2 is the second chromaticity C2.

FIG. 26 illustrates color rendering indices of output light from the comparative example illustrated in FIG. 8 and Example 1 and Example 2 of the light emitting device illustrated in FIG. 1. In Example 1, the rotation angle θ is set to 135 degrees. In Example 2, the rotation angle θ is set to 180 degrees. As illustrated in FIG. 26, all of the color rendering indices of Examples 1 and 2 are high. For example, the color rendering index R9 is less than 90 in the comparative example while exceeding 90 in Examples 1 and 2. In such a manner, the color rendering indices are raised by setting the chromaticity difference ΔC not greater than 0.04 and setting the rotation angle θ of the chromaticity vector to 135 to 180 degrees.

According to the inventors' consideration, the dependence of the differences ΔU and Δv on the rotation angle θ shows a local maximum value or a local minimum value when the difference between the peak wavelengths of the first and second blue light emitting elements 11 and 21 is excessively large or excessively small. After a great deal of consideration, the inventors have found that when the difference between the peak wavelengths of the first and second blue light emitting elements 11 and 21 is 20 to 40 nm, the local maximum value and local minimum value of the difference is reduced. In order to minimize the color difference ΔE, the difference between the peak wavelengths of the blue light emitting elements is preferably 20 to 40 nm.

The inventors have confirmed that the color difference ΔE is minimized when the peak wavelength of the first blue light emitting element 11 is in a wavelength range from 435 to 445 nm and the peak wavelength of the second blue light emitting element 21 is in a wavelength range from 455 to 470 nm. To improve the color rendering properties of the output light from the light emitting device, the peaks of the first and second blue light emitting elements 11 and 21 are preferably separated completely.

Meanwhile, the output lights from the first and second light emitting units 10 and 20 preferably have emission spectra with less variation in wavelength distribution. The kinds of the blue light emitting elements and phosphors included in the phosphor layer are properly selected. Hereinafter, preferable examples of phosphors included in the first and second phosphor layers 12 and 22 are shown.

The first phosphor layer 12 includes a green phosphor that is excited by the light emitted from the first blue light emitting element 11 to emit green light and a red phosphor that is excited by the light emitted from the first blue light emitting element 11 to emit red light. The components and composition of the green phosphor and red phosphor in the first phosphor layer 12 are configured so that the first light emitting unit 10 outputs the white light L1 having the first chromaticity C1. The second phosphor layer 22 includes a green phosphor that is excited by the light emitted from the second blue light emitting element 21 to emit green light and a red phosphor that is excited by the light emitted from the second blue light emitting element 21 to emit red light. The components and composition of the green phosphor and red phosphor in the second phosphor layer 22 are configured so that the second light emitting unit 20 outputs the white light L2 having the second chromaticity C2.

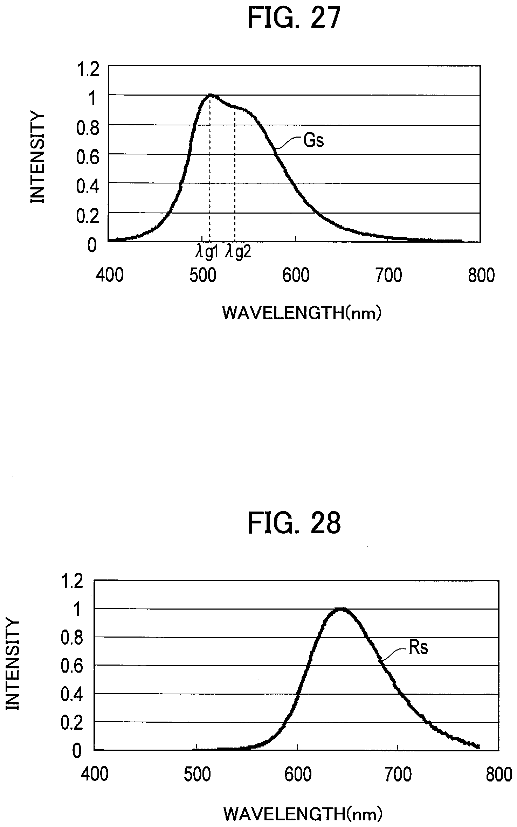

The aforementioned green phosphors are phosphors that emit green light having an emission spectrum with a first intensity at a first wavelength and a second intensity, which is smaller than the first intensity, at a second wavelength, for example. Specifically, a green phosphor that emits green light having an emission spectrum Gs illustrated in FIG. 27 is used in the light emitting device. In the emission spectrum example illustrated in FIG. 27, a first wavelength $\lambda g1$ corresponding to the first intensity is located in a short wavelength side of a second wavelength $\lambda g2$ corresponding to the second intensity, which is smaller than the first intensity. In other words, the emission spectrum of green excitation light emitted from the green phosphor includes a first peak value at the first wavelength $\lambda g1$ and a second peak value, which is smaller than the first peak value, at the second wavelength $\lambda g2$, which is longer than the first wavelength $\lambda g1$.

The red phosphors are phosphors that emit red light and have an absorption spectrum in which green light is absorbed more at the first wavelength $\lambda g1$ than at the second wavelength $\lambda g2$. FIG. 28 illustrates an example of an emission spectrum Rs of red excitation light emitted from such a red phosphor.

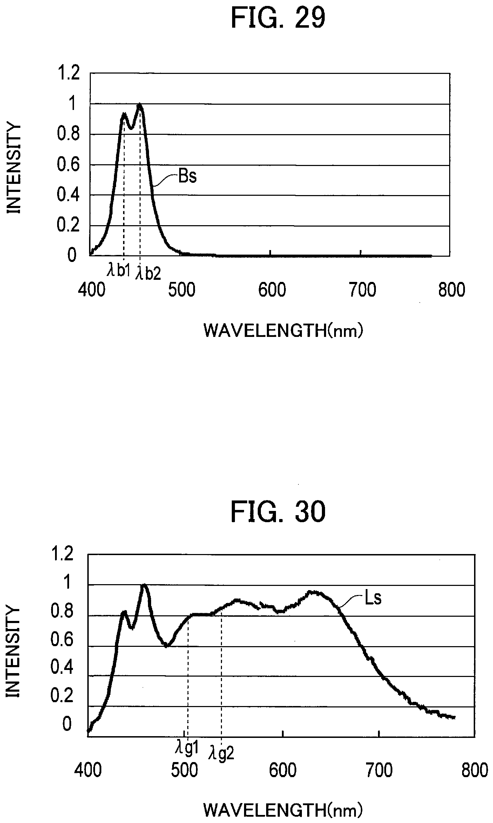

FIG. 29 illustrates an emission spectrum Bs which is a combination of emission spectra of the first blue light emitting element 11 and second blue light emitting element 21. In FIG. 29, wavelength $\lambda b1$ indicates the peak wavelength of the first blue light emitting element 11 while wavelength $\lambda b2$ indicates the peak wavelength of the second blue light emitting element 21.

Each light emitting unit outputs, as output light, a mixture of blue light emitted from the blue light emitting element, green light emitted from the green phosphor, and red light emitted from the red phosphor. FIG. 30 illustrates an emission spectrum Ls of the output light of the mixture of green light, red light, and blue light, the emission spectra of which are illustrated in FIGS. 27 to 29, respectively.

The emission spectrum Gs illustrated in FIG. 27 is different from the emission spectrum Ls illustrated in FIG. 30 in terms of intensity in the wavelength range of green light. In FIG. 27, the intensity at the first wavelength $\lambda g1$ is greater than the intensity at the second wavelength $\lambda g2$. In FIG. 30, the intensity at the first wavelength $\lambda g1$ is smaller than the intensity at the second wavelength $\lambda g2$. This is because the red phosphor has an absorption spectrum in which green light is less absorbed at the second wavelength $\lambda g2$ than at the first wavelength $\lambda g1$. In other words, the red phosphor uses more green light at the first wavelength $\lambda g1$ than at the second wavelength $\lambda g2$, and the intensities at the first and second wavelengths $\lambda g1$ and $\lambda g2$ are inverted. This results in provision of the output light having the emission spectrum Ls that varies less in wavelength distribution and is spectrally balanced as illustrated in FIG. 30.

The green phosphor that emits green light having the emission spectrum Gs illustrated in FIG. 27 is an oxide-based phosphor or the like. Specifically, the green phosphor is a scandate or a scandium oxide with $Ce^{3+}$ as the activator. The emission spectrum thereof includes two peak values due to transit to two separated ground levels in the crystal field. For examples, $CaSc_2O_4:Ce^{3+}$, $Ca_3Sc_2Si_3O_{12}:Ce^{3+}$, and $Ca_3(Sc, Mg)_2Si_3O_{12}:Ce^{3+}$, which are activated by $Ce^{3+}$, can be used as the green phosphor. Such a green phosphor emits green light having an emission spectrum in which the first wavelength $\lambda g1$ corresponding to the first peak value is in the shorter wavelength side of the second wavelength $\lambda g2$ corresponding to the second peak value, which is smaller than the first peak value.

The red phosphor is an nitride-based phosphor having a wide bandwidth or the like. As the red phosphor having an absorption spectrum in which absorption is greater at the first wavelength $\lambda g1$ than at the second wavelength $\lambda g2$, aluminum nitride phosphors activated by $Eu^{2+}$ can be used, such as $CaAlSiN_3:Eu^{2+}$ and $(Sr, Ca)AlSiN_3:Eu^{2+}$.

As described above, in the light emitting device according to the first embodiment of the invention, the chromaticity of the white light L1 outputted from the first light emitting unit 10 and the chromaticity of the white light L2 outputted from the second light emitting unit 20 are located symmetrically with respect to the target chromaticity, and the differences between the chromaticities of the white lights L1 and L2 and the target chromaticity are not greater than 0.04. This allows for the light emitting device capable of outputting white light having a predetermined chromaticity with all the color rendering indices being high. In order to reduce the color difference ΔE and raise the color rendering indices, it is preferable that the rotation angle θ of the chromaticity vector is set to 135 to 180 degrees and the difference between the peak wavelengths of the first and second blue light emitting elements 11 and 21 is set to 20 to 40 nm.

<Example of Lamp Fitting (Lighting Device)>

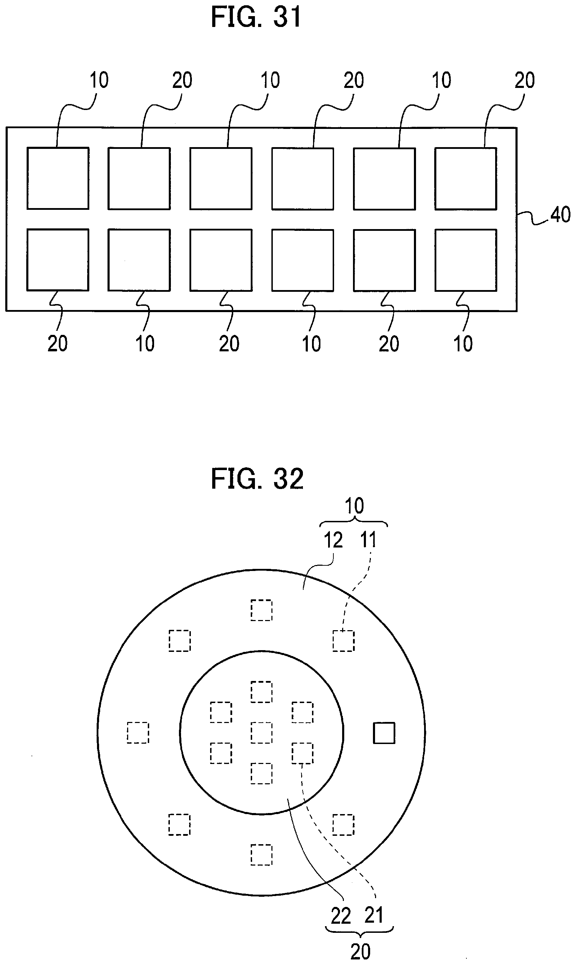

A light emitting device includes a plurality of the first light emitting units 10 and a plurality of the second light emitting units 20, which are alternately arranged in a line. The light emitting device is covered with an opaque light-diffusing lamp-fitting cover, thus implementing a lamp fitting with extremely high color rendering properties. As illustrated in FIG. 31, the first light emitting units 10 and the second light emitting units 20 are alternately arranged in the horizontal direction and vertical direction in a plan view and are covered with an opaque and light-diffusing lamp-fitting cover, thus implementing a lamp fitting with extremely high color rendering properties.

(Second Embodiment)

The above description shows the case where one light emitting unit is provided with one blue light emitting element by way of example. However, one light emitting unit may be provided with plural blue light emitting elements. This can increase the luminous flux without increasing the area of the light emitting device.

Furthermore, a chip on board (COB) light emitting device may be implemented using a light emitting unit of various shapes provided with plural blue light emitting elements. For example, the first light emitting unit 10 each including plural first blue light emitting elements 11 is arranged around the second light emitting unit 20 including plural second blue light emitting elements 21 on a substrate. In the example illustrated in FIG. 32, the first and second light emitting units 10 and 20 are arranged concentrically in a plan view. Specifically, the first light emitting unit 10 is annular in a plan view and is located outside of the second light emitting unit 20, which is circular in a plan view.

In FIG. 32, the plural first blue light emitting elements 11 are covered with the single first phosphor layer 12 in the first light emitting unit 10. In the second light emitting unit 20, the plural second blue light emitting elements 21 are covered with the single second phosphor layer 22. For example, the first and second light emitting units 10 and 20 are formed by placing the first and second blue light emitting elements 11 and 21 at predetermined positions and separately applying the phosphor layers.

In the example illustrated in FIG. 32, the outline of the light emitting units is circular. The outline of the light emitting units may be rectangular or polygonal. The light emitted from the first blue light emitting elements 11 with a shorter peak wavelength is more likely to be absorbed by the light emitted from the second blue light emitting element with a longer peak wavelength. It is therefore preferable that the second light emitting unit 20 is located inside while the first light emitting unit 10 is located outside.

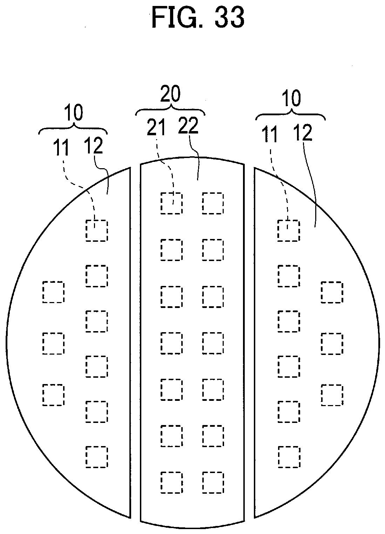

Alternatively, as illustrated in FIG. 33, the first light emitting units 10, which are semicircular and include a plurality of the first blue light emitting elements 11, may be located on both sides of the second light emitting unit 20, which is belt-shaped and includes a plurality of the second blue light emitting elements 21.

As described above, the first and second light emitting units 10 and 20 can be of various shapes, and the arrangement places thereof can be combined properly. The light emitting device according to the second embodiment is able to output white light with a predetermined chromaticity and output high-luminance light having an emission spectrum with all the color rendering indices being raised. The other configurations are the same as those of the first embodiment, the redundant description is omitted.

(Other Embodiment)

As described above, the invention is described with the embodiments. However, it should not be understood that the description and drawings constituting a part of the disclosure will limit the invention. Various substitutions, examples, and operational techniques will be obvious for those skilled in the art from the disclosure.

For example, a lamp fitting covering the first and second light emitting units 10 and 20 may be provided on the substrate 40. The output light from the first light emitting unit 10 and the output light from the second light emitting unit 20 are mixed within the lamp fitting, so that white light with a predetermined chromaticity is outputted from the light emitting device.

In the examples described in the aforementioned embodiments, the green phosphor emits green light having an asymmetric emission spectrum with a major peak in the short wavelength side. However, it is possible to use a green phosphor that emits green light having an emission spectrum with a major peak in the long wavelength side. In such a case, the red phosphor has an absorption spectrum with a major peak in the long wavelength side.

It is certain that the invention includes various embodiments not described in the specification. The technical range of the invention is determined by only the matters specifying the claims.

[Industrial Applicability]

The light emitting device of the invention is applicable to light emitting devices that output light by exciting a phosphor with light emitting elements.

**Claims**

1. A light emitting device comprising:

   a first light emitting unit which includes:

      a first blue light emitting element that emits first emission light having an emission spectrum in which the peak wavelength is a first wavelength; and
      a first phosphor layer which is excited with the first emission light to emit a first excitation light

   and outputs white light of a first chromaticity which is a mixture of the first emission light and the first excitation light; and
   a second light emitting unit which includes:

      a second blue light emitting element that emits second emission light having an emission spectrum in which the peak wavelength is a second wavelength, the second wavelength being longer than the first wavelength; and
      a second phosphor layer which is excited with the second emission light to emit a second excitation light

   and outputs white light of a second chromaticity which is a mixture of the second emission light and the second excitation light, wherein
   in an xy chromaticity diagram, the first chromaticity and second chromaticity are located symmetrically with respect to a predetermined chromaticity, and the difference between the predetermined chromaticity and each of the first and second chromaticities is not greater than 0.04, and
   the white light of the first chromaticity and the white light of the second chromaticity are mixed to be outputted as light of the predetermined chromaticity.

2. The light emitting device according to claim 1, wherein in the xy chromaticity diagram, the difference between the predetermined chromaticity and each of the first and second chromaticities is not less than 0.01.

3. The light emitting device according to claim 1, wherein a color difference corresponding to the distance between the predetermined chromaticity and each of the first and second chromaticities in an L*a*b* color space is not greater than 2.

4. The light emitting device according to claim 1, wherein in the xy chromaticity diagram, an angle between a line that connects the first chromaticity as the start point to the second chromaticity at the end point and the +x direction of the xy chromaticity diagram is 135 to 180 degrees.

5. The light emitting device according to claim 1, wherein the difference between the first and second wavelengths is 20 to 40 nm.

6. The light emitting device according to claim 5, wherein the first wavelength is in a wavelength range from 435 to 445 nm while the second wavelength is in a wavelength range from 455 to 470 nm.

7. The light emitting device according to claim 1, wherein
   the first phosphor layer includes a green phosphor and a red phosphor which are excited by the first emission light to emit green light and red light, respectively, with components and composition that are configured to allow the first light emitting unit to output white light of the first chromaticity,

the second phosphor layer includes a green phosphor and a red phosphor which are excited by the second emission light to emit green light and red light, respectively, with components and composition that are configured to allow the second light emitting unit to output white light of the second chromaticity,

the green phosphor emits green light that has an emission spectrum including a first wavelength corresponding to a first intensity and a second wavelength corresponding to a second intensity that is smaller than the first intensity, and the red phosphor emits red light that has an absorption spectrum in which the green light is absorbed more at the first wavelength corresponding to the first intensity than at the second wavelength corresponding to the second intensity.

8. The light emitting device according to claim 1, wherein the first light emitting unit includes a plurality of the first blue light emission elements and is located around the second light emitting unit, and the second light emitting unit includes a plurality of the second blue light emitting elements.

# FIG. 1

# FIG. 2

# FIG. 3

| Ra | 83 |
|---|---|
| R1 | 89 |
| R2 | 84 |
| R3 | 79 |
| R4 | 79 |
| R5 | 88 |
| R6 | 81 |
| R7 | 79 |
| R8 | 82 |
| R9 | 67 |
| R10 | 63 |
| R11 | 85 |
| R12 | 66 |
| R13 | 86 |
| R14 | 88 |
| R15 | 84 |

# FIG. 4

WAVELENGTH(nm)

# FIG. 5

| Ra | 79 |
|---|---|
| R1 | 81 |
| R2 | 79 |
| R3 | 82 |
| R4 | 80 |
| R5 | 81 |
| R6 | 75 |
| R7 | 79 |
| R8 | 79 |
| R9 | 42 |
| R10 | 56 |
| R11 | 86 |
| R12 | 62 |
| R13 | 78 |
| R14 | 91 |
| R15 | 75 |

# FIG. 6

## FIG. 7

| | |
|---|---|
| Ra | 98 |
| R1 | 97 |
| R2 | 98 |
| R3 | 99 |
| R4 | 99 |
| R5 | 98 |
| R6 | 97 |
| R7 | 99 |
| R8 | 98 |
| R9 | 93 |
| R10 | 96 |
| R11 | 97 |
| R12 | 95 |
| R13 | 97 |
| R14 | 99 |
| R15 | 97 |

## FIG. 8

# FIG. 9

# FIG. 10

## FIG. 11

## FIG. 12

# FIG. 13

# FIG. 14

EP 3 419 062 A1

# FIG. 15

# FIG. 16

(a)                                    (b)

# FIG. 17

# FIG. 18

# FIG. 19

# FIG. 20

# FIG. 21

LIGHT OUTPUT RATIO

# FIG. 22

LIGHT OUTPUT RATIO

# FIG. 23

# FIG. 24

## FIG. 25

## FIG. 26

| COLOR RENDERING INDEX | COMPARATIVE EXAMPLE | EXAMPLE 1 (135°) | EXAMPLE 2 (180°) |
|---|---|---|---|
| Ra | 96.4 | 98.2 | 98.3 |
| R1 | 98.0 | 98.8 | 98.1 |
| R2 | 97.2 | 99.5 | 99.8 |
| R3 | 95.8 | 97.3 | 96.7 |
| R4 | 95.4 | 96.8 | 97.2 |
| R5 | 97.1 | 98.5 | 98.1 |
| R6 | 97.4 | 98.8 | 98.9 |
| R7 | 95.8 | 98.1 | 99.0 |
| R8 | 94.6 | 98.1 | 98.3 |
| R9 | 89.1 | 97.5 | 97.9 |
| R10 | 93.5 | 98.6 | 98.9 |
| R11 | 95.3 | 95.4 | 96.0 |
| R12 | 91.1 | 95.1 | 98.7 |
| R13 | 97.8 | 99.0 | 98.6 |
| R14 | 97.1 | 97.7 | 97.3 |
| R15 | 95.9 | 98.8 | 98.4 |

# FIG. 27

# FIG. 28

# FIG. 29

# FIG. 30

# FIG. 31

10    20    10    20    10    20

40

20    10    20    10    20    10

# FIG. 32

10
12  11

22  21

20

# FIG. 33

## INTERNATIONAL SEARCH REPORT

| International application No. |
| --- |
| PCT/JP2016/071394 |

| A. CLASSIFICATION OF SUBJECT MATTER |
| --- |
| *H01L33/50*(2010.01)i |

According to International Patent Classification (IPC) or to both national classification and IPC

| B. FIELDS SEARCHED |
| --- |
| Minimum documentation searched (classification system followed by classification symbols) |
| H01L33/00-33/64 |

Documentation searched other than minimum documentation to the extent that such documents are included in the fields searched

| | | | |
| --- | --- | --- | --- |
| Jitsuyo Shinan Koho | 1922-1996 | Jitsuyo Shinan Toroku Koho | 1996-2016 |
| Kokai Jitsuyo Shinan Koho | 1971-2016 | Toroku Jitsuyo Shinan Koho | 1994-2016 |

Electronic data base consulted during the international search (name of data base and, where practicable, search terms used)

| C. DOCUMENTS CONSIDERED TO BE RELEVANT | | |
| --- | --- | --- |
| Category* | Citation of document, with indication, where appropriate, of the relevant passages | Relevant to claim No. |
| A | JP 2015-126160 A (Sanken Electric Co., Ltd.), 06 July 2015 (06.07.2015), paragraphs [0032], [0045] to [0052]; fig. 19 (Family: none) | 1-8 |
| A | JP 2014-112621 A (Mitsubishi Chemical Corp.), 19 June 2014 (19.06.2014), paragraphs [0108] to [0113]; fig. 21 (Family: none) | 1-8 |
| A | JP 2013-045839 A (Mitsubishi Electric Corp.), 04 March 2013 (04.03.2013), paragraph [0013]; fig. 2 (Family: none) | 1-8 |

| ☒ Further documents are listed in the continuation of Box C. | ☐ See patent family annex. |
| --- | --- |

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| 20 September 2016 (20.09.16) | 27 September 2016 (27.09.16) |

| Name and mailing address of the ISA/ | Authorized officer |
| --- | --- |
| Japan Patent Office 3-4-3,Kasumigaseki,Chiyoda-ku, Tokyo 100-8915,Japan | Telephone No. |

Form PCT/ISA/210 (second sheet) (January 2015)

31

**EP 3 419 062 A1**

## INTERNATIONAL SEARCH REPORT

| International application No. |
| --- |
| PCT/JP2016/071394 |

C (Continuation).    DOCUMENTS CONSIDERED TO BE RELEVANT

| Category* | Citation of document, with indication, where appropriate, of the relevant passages | Relevant to claim No. |
| --- | --- | --- |
| A | JP 2010-218991 A  (Hitachi, Ltd.),<br>30 September 2010 (30.09.2010),<br>paragraphs [0072], [0073]<br>(Family: none) | 1-8 |
| A | JP 2016-129229 A  (Citizen Electronics Co.,<br>Ltd.),<br>14 July 2016 (14.07.2016),<br>paragraphs [0047] to [0050], [0087] to [0089];<br>fig. 6, 18<br>& US 2016/0223159 A<br>paragraphs [0067] to [0070], [0107] to [0109];<br>fig. 6, 18 | 8 |

Form PCT/ISA/210 (continuation of second sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2011029497 A

- JP 2015100664 A